# EUROPÄISCHE PATENTANMELDUNG

(11) **EP 4 498 109 A1**
(43) Veröffentlichungstag der Anmeldung: **29.01.2025**
(21) Anmeldenummer: 23188103.8
(22) Anmeldetag: 27.07.2023
(51) Int. Cl.: G01R 33/38, G01R 33/3815, G01R 33/385

(54) **KÜHLSYSTEM MIT AUFGETEILTEN KÜHLKREISLÄUFEN FÜR EIN MAGNETRESONANZSYSTEM, MAGNETRESONANZSYSTEM UND VERFAHREN**

(71) Anmelder: Siemens Healthineers AG, 91301 Forchheim (DE)
(72) Erfinder: Grübel, Sören, 91054 Erlangen (DE); Kröckel, Horst, 96052 Bamberg (DE); Nerreter, Ulrich, 90402 Nürnberg (DE); Plumeyer, Martin, 91088 Bubenreuth (DE)
(74) Vertreter: Siemens Healthineers Patent Attorneys

(57) **Zusammenfassung**

Die Erfindung betrifft ein Kühlsystem (12) für ein Magnetresonanzsystem (1), aufweisend:
- einen ersten Kühlkreislauf (13) zur Wärmeübertragung von Wärme einer Magneteinheit (15) des Magnetresonanzsystems (1),
- zumindest einen zum ersten Kühlkreislauf (13) verschiedenen zweiten Kühlkreislauf (14) zur Wärmeübertragung von Wärme zumindest einer zur Magneteinheit (15) verschiedenen Komponente (17, 18) des Magnetresonanzsystems (1),
- zumindest eine Pumpeneinrichtung (26) zum Transport eines Kühlmediums in dem ersten Kühlkreislauf (13) und/oder in dem zweiten Kühlkreislauf (14), und
- zumindest eine Steuervorrichtung (27) zum Steuern des ersten und/oder zweiten Kühlkreislaufs (13, 14) und der Pumpeneinrichtung (26).

Des Weiteren betrifft die Erfindung ein Magnetresonanzsystem (1) und ein Verfahren.

## Beschreibung

Die Erfindung betrifft ein Kühlsystem für ein Magnetresonanzsystem. Des Weiteren betrifft die Erfindung ein Magnetresonanzsystem mit einer Bildgebungsmodalität und einem Kühlsystem. Ebenfalls betrifft die Erfindung ein Verfahren zum Kühlen eines Magnetresonanzsystems.

In der Kernspintomographie werden starke, hochfrequente Felder dazu genutzt, die Spins im Körper eines Patienten anzuregen. Felder im Bereich von bis zu 40 µT bei Frequenzen bis 300 MHz oder mehr werden von Pulsverstärkern mit mehreren 10 kW Sendeleistung erzeugt.

High-End-Systeme in der MRT (Magnetresonanztomographie) werden mit immer stärkeren Gradientenfeldern ausgestattet.

Zur Erzeugung der Magnetfelder benötigen Magnetresonanztomographen beziehungsweise Magnetresonanzsysteme umfangreiche und komplexe Kühlvorrichtungen. Eine der größten Leistungsverbraucher eines Magnetresonanzsystems ist die Systemkühlung, insbesondere bei supraleitenden Magneten. Die Wasserpumpe des Kühlsystems läuft hier dauerhaft, also insbesondere das gesamte Jahr, um den Magneten im supraleitenden Zustand zu halten. Während des Scans, also einer Schnittbildaufnahme des Körpers des Patienten wird viel Abwärme erzeugt, vor allem im Gradientensystem, die über das Kühlwasser abgeführt werden muss und den Leistungsverbrauch des Kühlsystems dem entsprechend erhöht.

In Summe ist das Kühlsystem deshalb für einen signifikanten Anteil an den Betriebskosten eines Magnetresonanzsystems verantwortlich. Eine Reduzierung der Energiekosten ist aus ökonomischen und ökologischen Gesichtspunkten angebracht.

Weiter werden an das Kühlsystem hohe Anforderungen hinsichtlich Zuverlässigkeit gestellt, da sich nach Ausfall der Kühlung der Magnet erwärmt und es zum "Quench" oder Runterfahren des Magnetfeldes kommen kann.

In bisherigen Magnetresonanzsystemen weisen Kühlsysteme verschiedene Betriebsmodi auf, in denen die Pumpendrehzahl und damit die aufgenommene Leistung an den Lastzustand angepasst werden kann. Hierbei gibt es beispielsweise einen Normal-Betriebsmodus, bei welchem die Pumpe so angesteuert werden kann, dass der definierte Differenzdruck eingehalten wird. Mit sich einstellendem Durchfluss kann die maximal im System anfallende Wärme abgeführt werden.

Des Weiteren gibt es einen Eco-Mode, welcher dann verwendet wird, wenn kein Scan läuft und somit der Soll-Wert des Differenzdrucks abgesenkt wird, wodurch die Pumpendrehzahl sinkt. Dies senkt die Leistungsaufnahme.

Des Weiteren gibt es einen "Night-Mode". Wenn das MRT ausgeschaltet ist, wird der Soll-Wert des Differenzdrucks weiter abgesenkt, wodurch die Pumpendrehzahl und die Leistungsaufnahme sinken.

Nachteilig ist hierbei jedoch, dass innerhalb der Betriebsmodi keine Anpassung an die abzuführende Wärmemenge erfolgt, so dass die Leistungsaufnahme innerhalb eines Modus konstant ist.

Eine Aufgabe der vorliegenden Erfindung besteht darin, ein Magnetresonanzsystem effizienter kühlen zu können, so dass eine Leistungsaufnahme des Magnetresonanzsystems reduziert werden kann.

Diese Aufgabe wird durch ein Kühlsystem, ein Magnetresonanzsystem sowie ein Verfahren gemäß den unabhängigen Patentansprüchen gelöst. Sinnvolle Weiterbildungen ergeben sich aus den abhängigen Patentansprüchen.

Ein Aspekt der Erfindung betrifft ein Kühlsystem für ein Magnetresonanzsystem, aufweisend:
- einen ersten Kühlkreislauf zur Wärmeübertragung von Wärme einer Magneteinheit des Magnetresonanzsystems,
- zumindest einen zum ersten Kühlkreislauf verschiedenen zweiten Kühlkreislauf zur Wärmeübertragung von Wärme zumindest einer zur Magneteinheit verschiedenen Komponente des Magnetresonanzsystems,
- zumindest eine Pumpeneinrichtung zum Transport eines Kühlmediums in dem ersten Kühlkreislauf und/oder in dem zweiten Kühlkreislauf, und
- zumindest eine Steuervorrichtung zum Steuern des ersten und/oder zweiten Kühlkreislaufs und der Pumpeneinrichtung.

Durch das erfindungsgemäße Kühlsystem können Magnetresonanzsysteme effizienter betrieben werden, da eine verbesserte Kühlung bereitgestellt werden kann. Folglich kann eine Leistungsaufnahme des Magnetresonanzsystems reduziert werden, da wiederum die benötigte Leistung beziehungsweise benötige Energie des Kühlsystems minimiert werden kann. Mit Hilfe des erfindungsgemäßen Kühlsystems kann ein Magnetresonanzsystem ökonomischer und ökologischer betrieben werden, da ein Energiebedarf des Kühlsystems und somit des Magnetresonanzsystems reduziert wird.

Mit Hilfe des Kühlsystems können für verschiedene Komponenten beziehungsweise Systeme des Magnetresonanzsystems eigene Kühlkreisläufe bereitgestellt werden. Dies bringt den Vorteil mit sich, dass ein Kühlkreis für die Magneteinheit, mittels welcher das Magnetfeld erzeugt werden kann, vorliegt. Die Magneteinheit ist insbesondere die Einheit eines Magnetresonanzsystems, welche in der Regel im Dauerbetrieb ist. Komponenten des Magnetresonanzsystems, welche wiederum nicht ständig benötigt werden und entgegen der Magneteinheit ausgeschaltet werden können, zumindest temporär, können dem weiteren Kühlkreislauf zugeordnet werden. Wenn also diese Komponenten nicht benötigt und somit in einem inaktiven Betrieb sind und somit nicht gekühlt werden müssen, kann der weitere beziehungsweise zweite Kühlkreislauf mittels der Steuervorrichtung ausgeschaltet beziehungsweise abgetrennt werden.

Das erfindungsgemäße Kühlsystem bietet somit den Vorteil, dass je nach Betriebszustand des Magnetresonanzsystems und insbesondere je nach Aktivitätszustand einer Komponente des Magnetresonanzsystems die Kühlkreisläufe selektiv gesteuert beziehungsweise betrieben werden können. Dies bietet den Vorteil, dass bei einem inaktiven Zustand des Magnetresonanzsystems nur der Kühlkreislauf aktiv beziehungsweise betrieben wird, welcher zur Kühlung der Magneteinheit verwendet wird. Der weitere Kühlkreislauf beziehungsweise weitere Kühlkreisläufe können dagegen inaktiv beziehungsweise abgeschaltet beziehungsweise abgetrennt werden. Dies bringt Vorteile in der Leistungsaufnahme des Kühlsystems und somit eine vorteilhafte Energieeinsparung.

Mit der, insbesondere elektronischen, Steuervorrichtung, bei welcher es sich um ein Steuergerät handeln kann, kann das Kühlsystem gesteuert werden. Je nach Zustand des Magnetresonanzsystems können die Kühlkreisläufe gemeinsam und/oder unterschiedlich gesteuert werden. Hierzu kann des Weiteren die Pumpeneinrichtung beziehungsweise ein Pumpensystem derart angesteuert werden, dass ein entsprechender Kühlkreislauf mit Kühlmedium beaufschlagt beziehungsweise versorgt werden kann.

Mit Hilfe der Kühlkreisläufe kann eine Wärmeübertragung von der Magneteinheit und/oder weiteren Komponenten erfolgen. Mit anderen Worten ausgedrückt kann hier eine Kühlung beziehungsweise eine Wärmeabfuhr durchgeführt werden.

Bei dem ersten und zumindest zweiten Kühlkreislauf handelt es sich um zueinander unterschiedliche, separate und/oder getrennte Kreisläufe.

Insbesondere können die Kühlkreisläufe als Kühlmittelkreisläufe bezeichnet werden.

In einem Ausführungsbeispiel ist vorgesehen, dass der zweite Kühlkreislauf in mehrere Teil-Kühlkreisläufe unterteilt ist, wobei einer jeweiligen Komponente der zur Magneteinheit verschiedenen Komponenten jeweils einer der Teil-Kühlkreisläufe zugeordnet ist. Durch diese Selektierung beziehungsweise Unterteilung des zweiten Kühlkreislaufs kann das Kühlsystem spezifischer betrieben werden. Da jede Komponente des Magnetresonanzsystems beispielsweise einen eigenen Kühlkreislauf aufweisen kann, können die Kühlkreisläufe der Komponenten, welche sich in einem inaktiven beziehungsweise ausgeschalteten Zustand befinden, ebenfalls abgeschaltet werden. Somit kann eine individuelle und selektive Steuerung der Kühlkreisläufe erfolgen, um Energie sparen zu können. Nur die Komponenten, welche tatsächlich aktiv sind und eine Kühlung beziehungsweise Wärmeabfuhr benötigen, können durch Ansteuerung eines dazu entsprechenden Kühlkreislaufs gekühlt werden.

Mit anderen Worten ausgedrückt kann einer jeweiligen von der Magneteinheit verschiedenen Komponente des Magnetresonanzsystems ein eigener Teil-Kühlkreislauf zugewiesen beziehungsweise zugeteilt werden. Diese Teil-Kühlkreisläufe können wiederum mittels der Steuervorrichtung und insbesondere der Pumpeneinrichtung betrieben werden.

In einem Ausführungsbeispiel ist vorgesehen, dass die Steuervorrichtung mehrere Steuergeräte aufweist, wobei jeweils einem Kühlkreislauf und/oder jeweils einem Teil-Kühlkreislauf eine der mehreren Steuergeräte zugeordnet ist. Dadurch kann eine situationsangepasste beziehungsweise bedarfsgerechte Steuerung des Kühlsystems und somit des Kühlvorgangs betreffend das Magnetresonanzsystem durchgeführt werden. Somit können die Komponenten, welche gekühlt werden müssen, durch eine individuelle Ansteuerung eines individuellen Kühlkreislaufs gekühlt werden.

Bei der Steuervorrichtung kann es sich beispielsweise um eine Master-Steuereinheit handeln. Bei den mehreren Steuergeräten kann es sich wiederum um Slave-Steuergeräte handeln, welche durch die übergeordnete Steuervorrichtung angesteuert werden können.

In einem Ausführungsbeispiel ist vorgesehen, dass die Pumpeneinrichtung zumindest zwei Pumpeneinheiten aufweist, wobei eine erste Pumpeneinheit mit dem ersten Kühlkreislauf und eine zweite Pumpeneinheit dem zweiten Kühlkreislauf zugeordnet ist. Die Pumpeneinrichtung kann als übergeordnete Einheit für den Transport beziehungsweise für das Befördern des Kühlmediums, wie zum Beispiel einem Kühlmittel, vorgesehen sein. Zu dem jeweiligen ersten und zweiten Kühlkreislauf kann eine Pumpeneinheit, also eine Teil-Pumpeneinheit zugeordnet sein. Somit kann ein Durchfluss des Kühlmediums je nach Bedarfsfall angepasst werden. Durch die Aufteilung in mehrere Pumpeneinheiten können wiederum die Pumpeneinheiten der Kühlkreisläufe, welche aktuell nicht benötigt werden, inaktiv beziehungsweise abgeschaltet werden. Somit kann wiederum in einem Ruhezustand beziehungsweise inaktiven Zustand des Magnetresonanzsystems Energie eingespart werden.

In einem Ausführungsbeispiel ist vorgesehen, dass die Pumpeneinheiten als Nassläuferpumpen ausgebildet sind.

Als Nassläufer- beziehungsweise Nassläuferpumpen werden Pumpenaggregate bezeichnet, deren rotierende Teile sich einschließlich des Rotors beziehungsweise Läufers des antreibenden Elektromotors in dem flüssigen Fördermedium beziehungsweise Kühlmedium drehen, welches auch zur Kühlung und Lagerung gebraucht werden kann.

Durch die Aufteilung in mehrere Kühlkreisläufe beziehungsweise Teil-Kühlkreisläufe kann ein benötigter Durchfluss an Kühlmedium und ein vorliegender Druckabfall geringgehalten werden, so dass dort Nassläufer eingesetzt werden können. Die Nassläuferpumpen haben im Teillastbereich einen geringen Verbrauch, so dass diese zur Energieeinsparung positiv verwendet werden können. Zusätzlich haben Nassläuferpumpen eine höhere Zuverlässigkeit durch die hermetische Bauweise, sowie weniger Verschleißteile. Insbesondere für die Magnetkühlung beziehungsweise für die Kühlung der Magneteinheit ist dies ein großer Vorteil, da ein Ausfall der Wasserkühlung schnell zur Erwärmung des Magneten und damit zum "Quench" oder Herunterfahren des Magnetfelds führen kann.

In einem Ausführungsbeispiel ist vorgesehen, dass der erste Kühlkreislauf und/oder der zweite Kühlkreislauf steuerbare Ventile aufweisen, wobei die Ventile mittels der Steuervorrichtung steuerbar sind, um eine Durchflussmenge eines Kühlmittels in dem ersten und/oder zweiten Kühlkreislauf anzupassen. Je nach erfordertem Kühlbedarf beziehungsweise Betriebszustand beziehungsweise Betriebssituation des Magnetresonanzsystems können die Kühlkreisläufe individuell gesteuert beziehungsweise betrieben werden. Hierzu können mehrere steuerbare Ventile pro Kühlkreislauf vorgesehen sein. Ebenso denkbar ist, dass pro Kühlkreislauf beziehungsweise Teil-Kühlkreislauf ein steuerbares Ventil vorgesehen ist. Je nach Kühlbedarf einer Komponente des Magnetresonanzsystems kann eine Durchflussmenge eines Kühlmittels beziehungsweise Kühlmediums in dem entsprechenden Kühlkreislauf angepasst beziehungsweise variiert werden. Somit können die Komponenten, welche temporär eine starke Wärmeerzeugung aufweisen, stärker gekühlt werden, indem in dem entsprechenden Kühlkreislauf die Durchflussmenge erhöht wird. Komponenten, welche eine weniger starke Wärmeentwicklung aufweisen oder aktuell abgeschaltet sind, können mit einer niedrigeren Durchflussmenge des entsprechenden Kühlkreislaufs gekühlt werden. Ebenso können Kühlkreisläufe, welche aktuell nicht benötigt werden, da die entsprechenden Komponenten inaktiv sind, mit gar keinem Kühlmittel beaufschlagt werden. Hierbei kann das steuerbare Ventil entsprechend abgeschaltet beziehungsweise in einen Blockier-Zustand versetzt werden. Dadurch kann neben Energie auch ein Verschleiß und insbesondere ein Verbrauch an Kühlmittel reduziert werden.

In einem Ausführungsbeispiel ist vorgesehen, dass die Steuervorrichtung ausgebildet ist, eine Durchflussmenge eines Kühlmediums in dem ersten und/oder zweiten Kühlkreislauf auf Basis eines Betriebszustands des Magnetresonanzsystems zu steuern. Je nachdem, welcher Betriebszustand des Magnetresonanzsystems und insbesondere dessen Komponenten vorliegt, kann eine bedarfsgerechte beziehungsweise individuelle Kühlung beziehungsweise Wärmeabfuhr durchgeführt werden. Hierzu kann die Steuervorrichtung in den jeweiligen Kühlkreisläufen eine Durchflussmenge des Kühlmediums anpassen. Somit können Komponenten, welche eine hohe Wärmeentwicklung aufweisen, wie zum Beispiel die Magneteinheit, mit einer größeren Durchflussmenge in dem entsprechenden Kühlkreislauf vorgesehen sein. Sollte sich das Magnetresonanzsystem in einem inaktiven Zustand, also in einem Zustand, bei welchem kein Scan durchgeführt wird, befinden, so können die Kühlkreisläufe, welche nicht zur Kühlung der Magneteinheit verwendet werden, mit einer geringen oder gar keiner Durchflussmenge in entsprechenden Kühlkreisläufen versorgt werden.

Ein weiterer Aspekt der Erfindung betrifft ein Magnetresonanzsystem mit einer Bildgebungsmodalität und einem Kühlsystem nach dem vorherigen Aspekt oder einer vorteilhaften Weiterbildung davon.

Durch das eingangs genannte Kühlsystem kann das soeben geschilderte Magnetresonanzsystem und insbesondere die Bildgebungsmodalität gekühlt werden.

In einem Ausführungsbeispiel des weiteren Aspekts ist vorgesehen, dass die Magneteinheit eine Magnetkühleinheit aufweist, wobei mit der Magnetkühleinheit eine direkte Kühlung der Magneteinheit durchführbar ist, wobei die mittels der Magnetkühleinheit abgeführte Wärme der Magneteinheit von dem ersten Kühlkreislauf aufgenommen werden kann. Um mit dem Magnetresonanzsystem entsprechende Scan eines Körpers eines Patienten durchführen zu können, müssen mittels der Magneteinheit, wie zum Beispiel Spulen, starke Magnetfelder erzeugt werden. Hierzu fungiert die Magneteinheit als Supraleiter, welcher eine Kühlung auf sehr niedriger Temperatur, z.B. - 268°C, erfordert. Das Aufrechterhalten dieser Temperatur ist sehr energieintensiv. Mittels der Magnetkühleinheit kann eine entsprechende direkte Kühlung der Magneteinheit durchgeführt werden. Die von der Magnetkühleinheit abgeführte Wärme der Magneteinheit muss wiederum entsprechend weiter abgegeben werden. Hierzu kann der erste Kühlkreislauf verwendet werden. Da die Magnetkühleinheit im Wesentlichen ständig in Betrieb ist beziehungsweise läuft, wird speziell der erste Kühlkreislauf ebenso ständig benötigt. Dem gegenüber können wiederum die weiteren Kühlkreisläufe je nach Betriebszustand des Magnetresonanzsystems abgeschaltet werden.

In einem weiteren Ausführungsbeispiel des weiteren Aspekts ist vorgesehen, dass die Magnetkühleinheit einen Heliumkompressor aufweist, so dass mittels Helium die Magneteinheit kühlbar ist und wobei der erste Kühlkreislauf abhängig von einem Betriebszustand des Heliumkompressors steuerbar ist. Wie bereits erwähnt, benötigt die Magneteinheit eine sehr niedrige Kühltemperatur. Dies kann insbesondere mittels Helium erreicht werden. Hierbei kann das Helium tiefkalt verflüssigt sein und eine Temperatur von unter -268 °C aufweisen. Die von dem Helium aufgenommene Wärme kann wiederum an den ersten Kühlkreislauf abgegeben und von dem ersten Kühlkreislauf wiederum abtransportiert werden. Für die Kühlung der Magneteinheit kann wiederum der Heliumkompressor vorgesehen sein. Für das Steuern des ersten Kühlkreislaufs und insbesondere eine Durchflussmenge innerhalb des ersten Kühlkreislaufes kann ein Betriebszustand des Heliumkompressors berücksichtigt werden. Hierbei kann ein Widerstand beziehungsweise ein Druckabfall des Heliumkompressors für das Steuern des Kühlkreislaufs berücksichtigt werden. Je mehr Leistung der Heliumkompressor benötigt, desto mehr Kühlung wiederum mittels des ersten Kühlkreislaufs wird benötigt. Dies kann mittels der Steuervorrichtung überwacht und gesteuert werden.

In einem Ausführungsbeispiel des weiteren Aspekts ist vorgesehen, dass es sich bei der zumindest einen Komponente um einen Gradientenverstärker, eine Gradientenspule, einen Breitbandverstärker, eine Auswerteeinheit und/oder eine Steuereinrichtung handelt. Somit können hier für eine jeweilige dieser Komponenten beziehungsweise Einheiten beziehungsweise Einrichtungen ein entsprechender Kühlkreislauf zugeordnet beziehungsweise zugewiesen werden.

Ein weiterer Aspekt der Erfindung betrifft ein Verfahren zum Kühlen eines Magnetresonanzsystems, wobei mittels eines ersten Kühlkreislaufs eine Wärmeübertragung von Wärme einer Magneteinheit des Magnetresonanzsystems durchgeführt wird, mittels zumindest eines zum ersten Kühlkreislauf verschiedenen zweiten Kühlkreislauf eine Wärmeübertragung von Wärme zumindest einer zur Magneteinheit verschiedenen Komponente des Magnetresonanzsystems durchgeführt wird, mit zumindest einer Pumpeneinrichtung ein Kühlmedium in dem ersten Kühlkreislauf und/oder in dem zweiten Kühlkreislauf transportiert wird, und mit zumindest einer Steuervorrichtung der erste und/oder der zweite Kühlkreislauf und die Pumpeneinrichtung zum Durchführen einer Wärmeübertragung gesteuert werden.

Mit Hilfe des vorgeschlagenen Verfahrens kann ein Magnetresonanzsystem nach dem vorherigen Aspekt oder einer vorteilhaften Weiterbildung davon gekühlt werden.

Mit Hilfe des vorgeschlagenen Verfahrens kann ein Magnetresonanzsystem effizienter gekühlt werden, so dass Energie eingespart werden kann. Hierzu können verschiedene Kühlkreisläufe separat angesteuert werden, um bedarfsgerecht die Komponenten zu kühlen, welche aktuell in Betrieb sind.

In einem Ausführungsbeispiel des weiteren Aspekts ist vorgesehen, dass ein Systemzustand des Magnetresonanzsystems erfasst wird und/oder eine Temperatur der Magneteinheit und/oder der zumindest einen Komponente erfasst wird, wobei eine Information betreffend den erfassten Systemzustand und/oder die erfasste Temperatur beim Steuern der Kühlkreisläufe und/oder der Pumpeneinrichtung berücksichtigt werden.

Mittels Erfassungseinrichtungen und/oder Detektionseinheiten, wie Sensoren, können die verschiedensten Systeme und/oder Komponenten des Magnetresonanzsystems überwacht werden.

Bei dem Systemzustand kann es sich um einen inaktiven oder aktiven Zustand des Magnetresonanzsystems handeln. Hierbei kann beispielsweise unterschieden werden, ob ein Scan an einem Patienten durchgeführt wird oder in Vorbereitung ist oder ob aktuell keinerlei Untersuchungen an Patienten vorgesehen sind. Dies kann von einer Steuereinrichtung beziehungsweise einem Steuersystem des Magnetresonanzsystems bereitgestellt werden.

Mittels Temperatursensoren, wie zum Beispiel Temperaturfühlern, kann zu den jeweiligen Komponenten und insbesondere der Magneteinheit die vorliegende Temperatur erfasst werden. Auf Basis der erfassten Temperatur kann ein entsprechender Kühlkreislauf zur Kühlung dieser Komponente angesteuert werden. Die entsprechenden Informationen können wiederum der Steuervorrichtung bereitgestellt werden, so dass die Kühlkreisläufe und/oder die Pumpeneinrichtung bedarfsgerecht gesteuert werden können.

In einem Ausführungsbeispiel des weiteren Aspekts ist vorgesehen, dass auf Basis des erfassten Systemzustands der Temperatur der Magneteinheit, der Temperatur der Komponente und/oder einer Betriebsinformation des Magnetresonanzsystems eine potentielle Wärmeentwicklung der Magneteinheit und/oder der zumindest einen Komponente prädiziert wird. Die prädizierte beziehungsweise vorhergesagte Wärmeentwicklung der Magneteinheit und/oder der Komponente wird beim Steuern der Kühlkreisläufe und/oder der Pumpeneinrichtung berücksichtigt.

Auf Basis der erfassten und/oder bereitgestellten Informationen beziehungsweise Daten kann systemseitig bestimmt werden, wann insbesondere ein Scanvorgang an einem Patienten durchgeführt wird. Somit kann systemseitig festgestellt werden, zu welchem Zeitpunkt die Komponente des Magnetresonanzsystems hochgefahren werden müssen, um einen Scanvorgang durchführen zu können. Dies kann wiederum zur Vorkonditionierung beziehungsweise zur Einstellung des Kühlsystems verwendet werden. Somit kann ab dem Zeitpunkt, ab welchem die Komponenten hochgefahren werden, eine entsprechende Kühlung vorgenommen werden. Wenn alle Komponenten vollständig hochgefahren sind und insbesondere ein Scanvorgang unmittelbar vorliegt, kann eine entsprechende Kühlung aller entsprechenden aktiven Komponenten durchgeführt werden. Dies kann mit Hilfe der prädizierten Wärmeentwicklung der einzelnen Komponenten entsprechend vorgenommen werden, da eine Kühlleistung beziehungsweise ein Kühlbedarf einer jeweiligen Komponente vorhergesagt werden kann und die entsprechenden Kühlkreisläufe und insbesondere die Durchflussmenge an Kühlmittel entsprechend an die jeweilige Situation angepasst eingestellt werden kann.

Mit anderen Worten ausgedrückt kann, beispielsweise mit einer Auswerteeinheit des Magnetresonanzsystems, bestimmt werden, wie ein zukünftiger beziehungsweise voraussichtlich zu erwartender Wärme-Verlauf der einzelnen Komponenten aussieht, um dadurch das Kühlsystem entsprechend vorkonditionieren beziehungsweise vorbereiten zu können.

In einem Ausführungsbeispiel des weiteren Aspekts ist vorgesehen, dass der erste Kühlkreislauf auf Basis eines Betriebszustands der Magneteinheit und der zweite Kühlkreislauf auf Basis eines Betriebszustands der Komponente gesteuert werden. Somit kann für eine jeweilige Komponente eine Separierung der Steuerung der Kühlung vorgenommen werden. Somit kann eine individuelle beziehungsweise bedarfsgerechte Kühlung einer jeweiligen Komponente durchgeführt werden. Dies bringt vor allem dann Vorteile mit sich, wenn einzelne Komponenten aktuell keine Kühlung benötigen, so dass Teile des Kühlsystems inaktiv geschaltet werden können, um Energie zu sparen.

Insbesondere kann das Kühlsystem und/oder das Magnetresonanzsystem auch den vorherigen Aspekten Mittel, wie zum Beispiel technische Einheiten, aufweisen, um das soeben genannte Verfahren auszuführen beziehungsweise durchzuführen.

Für Anwendungsfälle oder Anwendungssituationen, die sich bei dem Verfahren ergeben können und die hier nicht explizit beschrieben sind, kann vorgesehen sein, dass gemäß dem Verfahren eine Fehlermeldung und/oder eine Aufforderung zur Eingabe einer Nutzerrückmeldung ausgegeben und/oder eine Standardeinstellung und/oder ein vorbestimmter Initialzustand eingestellt wird.

Unabhängig vom grammatikalischen Geschlecht eines bestimmten Begriffes sind Personen mit männlicher, weiblicher oder anderer Geschlechteridentität mit umfasst.

Zu der Erfindung gehören auch Weiterbildungen des erfindungsgemäßen Magnetresonanzsystems und des erfindungsgemäßen Verfahrens, die Merkmale aufweisen, wie sie bereits im Zusammenhang mit den Weiterbildungen des erfindungsgemäßen Kühlsystems beschrieben worden sind. Aus diesem Grund sind die entsprechenden Weiterbildungen des erfindungsgemäßen Magnetresonanzsystems und des erfindungsgemäßen Verfahrens hier nicht noch einmal beschrieben.

Die Erfindung umfasst auch die Kombinationen der Merkmale der beschriebenen Ausführungsformen.

Bei den im Folgenden erläuterten Ausführungsbeispielen handelt es sich um bevorzugte Ausführungsbeispiele der Erfindung. Bei den Ausführungsbeispielen stellen die beschriebenen Komponenten jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsbeispiele auch durch weitere der bereits beschriebenen Merkmale der Erfindung ergänzbar.

Die vorliegende Erfindung wird nun anhand der beigefügten Zeichnungen näher erläutert, in denen zeigen:
- FIG 1: eine schematische Ansicht eines Magnetresonanzsystems;
- FIG 2: eine schematische Ansicht des erfindungsgemäßen Kühlsystems mit aufgeteilten Kühlkreisläufen;
- FIG 3: eine weitere schematische Darstellung eines Ausführungsbeispiels des Kühlsystems;
- FIG 4: eine weitere schematische Darstellung einer Ausführungsform des erfindungsgemäßen Kühlsystems;
- FIG 5: eine schematische Darstellung betreffend eine dynamische Regelung des ersten Kühlkreislaufs des Kühlsystems;
- FIG 6: ein weiteres Ausführungsbeispiel betreffend eine dynamische Regelung des zweiten Kühlkreislaufs des Kühlsystems;
- FIG 7: ein weiteres Ausführungsbeispiel betreffend eine dynamische Regelung des ersten Kühlkreislaufs des Kühlsystems; und
- FIG 8: eine weitere schematische Darstellung einer dynamischen Regelung des zweiten Kühlkreislaufs des Kühlsystems.

Die nachfolgend näher geschilderten Ausführungsbeispiele stellen bevorzugte Ausführungsformen der vorliegenden Erfindung dar.

In den Figuren sind funktionsgleiche Elemente mit denselben Bezugszeichen versehen.

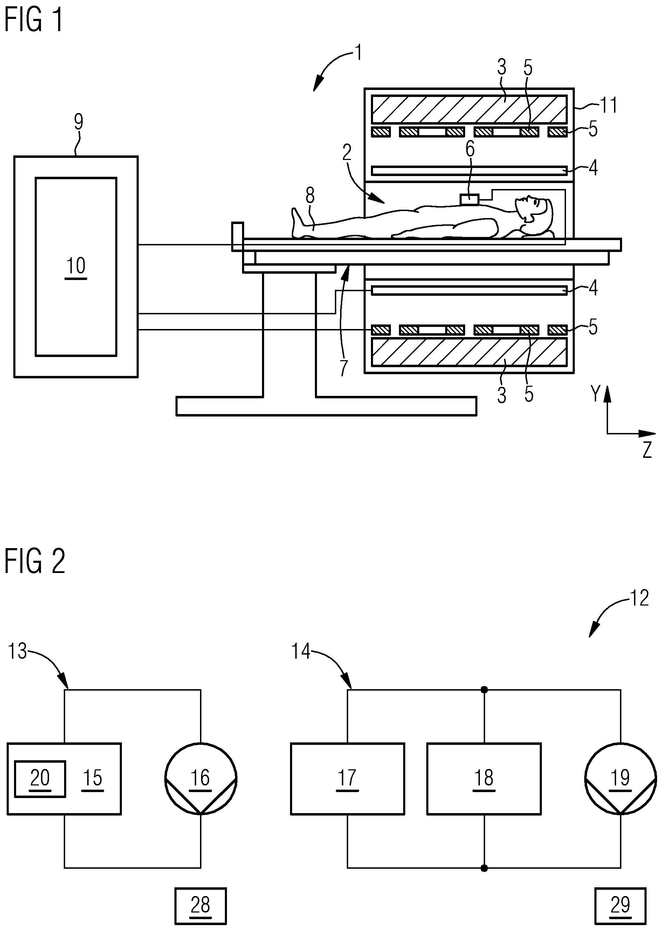

FIG 1 zeigt eine schematische Darstellung einer beispielhaften Ausführungsform eines erfindungsgemäßen (MRT-) Systems 1 (auch als Magnetresonanzsystem bezeichnet).

Das MRT-System 1 umfasst eine Magneteinheit mit einem Feldmagneten 3, der ein statisches Magnetfeld zur Ausrichtung von Kernspins eines Objekts 8, zum Beispiel eines Patienten, in einem Bildgebungsbereich erzeugt. Der Bildgebungsbereich ist durch ein äußerst homogenes statisches Magnetfeld gekennzeichnet, wobei sich die Homogenität insbesondere auf die Magnetfeldstärke beziehungsweise deren Amplitude bezieht. Der Bildgebungsbereich befindet sich in einem Patiententunnel 2, der sich in einer Längsrichtung Z durch die Magneteinheit erstreckt. Der Feldmagnet 3 kann beispielsweise ein supraleitender Magnet sein, der Magnetfelder mit einer magnetischen Flussdichte von bis zu 3 T oder mehr erzeugen kann. Für geringere Feldstärken können jedoch auch Permanentmagnete oder Elektromagnete mit normalleitenden Spulen verwendet werden. Ein Patiententisch beziehungsweise Untersuchungstisch 7 kann innerhalb des Patiententunnels 2 beweglich sein.

Weiterhin umfasst die Magneteinheit eine Gradientenspulenanordnung 5 mit mehreren Gradientenspulen, die dazu dienen, dem statischen Magnetfeld Gradientenfelder, also ortsabhängige Magnetfelder, in den drei Raumrichtungen zur räumlichen Differenzierung der abgetasteten Bildbereiche im Bildgebungsbereich zu überlagern. Die Gradientenspulen der Gradientenspulenanordnung 5 können zum Beispiel als Spulen aus normalleitenden Drähten ausgebildet sein, die zum Beispiel zueinander orthogonale Felder oder Feldgradienten im Bildgebungsbereich erzeugen können.

Die Magneteinheit umfasst eine Sendespulenanordnung, die beispielsweise eine Körperspule 4 (auch als Ganzkörperspule oder Body Coil bezeichnet) als Sendeantenne umfassen kann, die dazu ausgebildet ist, ein Hochfrequenzsignal bzw. Anregungssignal in den Bildgebungsbereich abzustrahlen. Die Körperspule 4 kann daher als HF-Sendespulenanordnung des MRT-Systems 1 verstanden werden oder als Teil der HF-Sendespulenanordnung. Die Körperspule 4 kann in einigen Ausführungsformen auch dazu verwendet werden, resonante MR-Signale zu empfangen, die von dem Objekt 8 ausgesendet werden. In diesem Fall kann die Körperspule 4 auch als Teil einer Signalerfassungsvorrichtung des MRT-Systems 1 betrachtet werden. Optional umfasst die Signalerfassungsvorrichtung eine lokale Spule 6 bzw. Lokalspule, die in unmittelbarer Nähe des Objekts 8, zum Beispiel an dem Objekt 8 oder in dem Patiententisch 7, angeordnet sein kann. Die lokale Spule 6 kann alternativ oder zusätzlich zur Körperspule 4 als Empfangsspule beziehungsweise Empfangsantenne dienen.

Das MRT-System 1 umfasst auch ein Steuer- und Rechensystem 9. Das Steuer- und Rechensystem 9 kann eine Sende-Empfangssteuereinheit 10 umfassen, die mit der Körperspule 4, der Gradientenspulenanordnung 5 und/oder der lokalen Spule 6 verbunden ist. In Abhängigkeit von den erfassten MR-Signalen kann die Sende-Empfangssteuereinheit 10, die einen Analog-DigitalWandler, ADC (englisch: "analog-to-digital converter") umfassen kann, entsprechende MR-Daten, insbesondere im k-Raum, erzeugen. Die Sende-Empfangssteuereinheit 10 ist gegebenenfalls auch mit der Körperspule 4 verbunden und steuert diese zur Erzeugung von HF-Impulsen, wie Anregungsimpulsen und/oder Refokussierungsimpulsen, an. Weiterhin kann die Sende-Empfangssteuereinheit 10 des Steuer- und Rechensystems 9 auch mit der Gradientenspulenanordnung 5 verbunden sein und diese steuern, um Schichtselektionsgradienten, Gradienten für die Frequenz- und/oder Phasencodierung und/oder Auslesegradienten zu schalten.

Beispielsweise weist das MRT-System 1 eine Bildgebungsmodalität 11 auf. Die Bildgebungsmodalität 11 kann zumindest die Magneteinheit, den Patiententisch 7 und den Patiententunnel 2 aufweisen.

In der FIG 2 ist eine schematische Darstellung des erfindungsgemäßen Kühlsystems 12 für das MRT-System 1 dargestellt. Das Kühlsystem 12 weist einen ersten Kühlkreislauf 13 und einen dazu separaten beziehungsweise getrennten zweiten Kühlkreislauf 14 auf. Ebenso können weitere Kühlkreisläufe vorgesehen sein. Mittels des ersten Kühlkreislaufs 13 kann eine Wärmeübertragung beziehungsweise Wärmeabfuhr von Wärme einer Magneteinheit 15 des MRT-Systems 1 durchgeführt werden. Die Magneteinheit 15 kann beispielsweise die Feldmagnete 3 enthalten. Um für die Wärmeübertragung beziehungsweise Wärmeabfuhr in dem Kühlkreislauf 13 ein Kühlmedium beziehungsweise ein Kühlmittel zirkulieren beziehungsweise fördern zu können, kann der Kühlkreislauf 13 eine erste Pumpeneinheit 16 aufweisen.

Mittels der Pumpeneinheit 16 kann entsprechend ein Kühlmedium befördert beziehungsweise zirkuliert werden. Mittels des zweiten Kühlkreislaufs 14 kann zumindest eine weitere Komponente 17 des Magnetresonanzsystems 1 und/oder weitere Komponenten 18 des MRT-Systems 1 gekühlt werden.

Beispielsweise kann es sich bei der Komponente 17 um die Gradientenspulenanordnung 5, welche beispielsweise einen Gradientenverstärker und zumindest eine Gradientenspule aufweist, handeln. Bei den weiteren Komponenten 18 kann es sich um Breitbandverstärker, Auswerteeinheiten und/oder Steuereinrichtungen des Magnetresonanzsystems 1 handeln.

Beispielsweise kann unter den weiteren Komponenten 18 das Steuer- und Rechensystem 9 und/oder die Sende-Empfangs-Steuereinheit 10 umfasst sein. Der zweite Kühlkreislauf 14, welcher wiederum getrennt zu dem ersten Kühlkreislauf 13 ausgebildet ist, kann ebenso eine eigene Pumpeneinheit, hier eine zweite Pumpeneinheit 19, aufweisen.

Das erfindungsgemäße Kühlsystem 12 bietet vor allem beim Thema Energieeinsparung und somit Effizienzsteigerung des MRT-Systems 1 Vorteile. Diese werden erreicht durch die Aufteilung in mehrere Kühlkreise.

Wie exemplarisch in der FIG 2 dargestellt, kann zur Kühlung der Magneteinheit 15 ein eigener Kühlkreislauf verwendet werden. Dahingehend können die restlichen Komponenten 17, 18 durch einen dazu separaten Kühlkreislauf gekühlt werden. Insbesondere benötigt eine Magnetkühleinheit beziehungsweise eine Magnetkühlung eine ständig laufende Kühlmittelkühlung beziehungsweise Wasserkühlung, da die Magneteinheit 15 zur Erzeugung eines Magnetfelds ständig laufen muss. Die anderen Komponenten 17, 18 benötigen eine Kühlung nur in eingeschaltetem Zustand oder sogar nur, wenn ein Scan läuft. Das Kühlsystem 12 kann in wenigstens zwei getrennte Kühlkreisläufe 13, 14 mit jeweils eigener Wasserpumpe beziehungsweise Pumpeneinheiten 16, 19 aufgeteilt werden. In ausgeschaltetem Zustand des MRT-Systems 1 kann somit die Kühlung für den Kühlkreislauf 14 komplett abgeschaltet oder zumindest deutlich reduziert werden, ohne die Magnetkühlung zu beeinflussen. Die Pumpe für die Magnetkühlung, also zur Kühlung der Magneteinheit 15, kann dadurch kleiner ausgelegt werden und im energetisch optimalen Bereich betrieben werden. Dies spart Energie im ausgeschalteten Systemzustand des MRT-Systems 1.

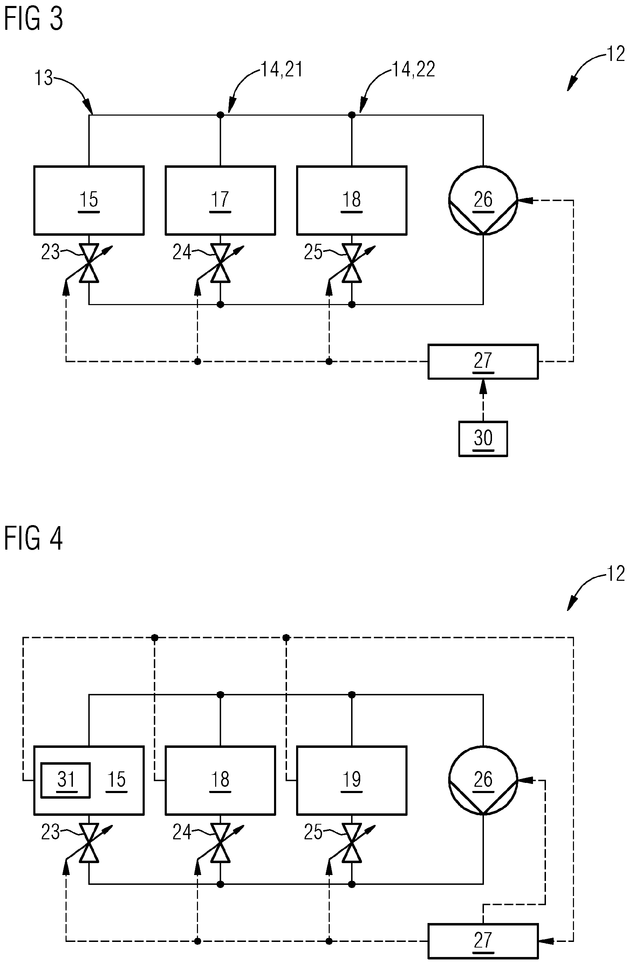

In der FIG 3 ist eine weitere schematische Darstellung des Kühlsystems 12 zu sehen. Beispielsweise kann der zweite Kühlkreislauf 14 in mehrere Teil-Kühlkreisläufe 21, 22 unterteilt beziehungsweise aufgeteilt werden. Somit kann ein Kühlkreislauf 13 für die Magneteinheit 15, ein Kühlkreislauf 21 für die Komponente 17 und zumindest ein weiterer Kühlkreislauf 22 für die weiteren Komponenten 18 vorgesehen sein. Somit können je nach Bedarf beziehungsweise je nach Gegebenheiten mehrere separate Kühlkreisläufe vorgesehen sein. Somit kann wiederum eine individuelle Kühlung und somit eine individuelle Steuerung vorgenommen werden. Hierbei können die einzelnen Kühlkreisläufe 13, 21, 22 durch steuerbare Ventile 23, 24, 25 gesteuert werden. Mittels dieser Ventile 23, 24, 25 können insbesondere die einzelnen Kühlkreisläufe 13, 21, 22 separiert voneinander werden. Um die einzelnen Kühlkreisläufe 13, 21, 22 steuern beziehungsweise betreiben zu können, kann anstelle der Ausführung in der FIG 2 eine übergeordnete Pumpeneinrichtung 26 vorgesehen sein. Mittels dieser Pumpeneinrichtung 26 kann eine Durchflussmenge eines Kühlmittels in den einzelnen Kühlkreisläufen bereitgestellt werden. Um die Pumpeneinrichtung 26 und insbesondere die Ventile 23, 24, 25 steuern beziehungsweise ansteuern zu können, kann das Kühlsystem 12 eine Steuervorrichtung 27 aufweisen.

Mit der Steuervorrichtung 27 können insbesondere alle Komponenten des Kühlsystems 2 angesteuert beziehungsweise überwacht beziehungsweise betrieben werden. Mittels der Steuervorrichtung 27 kann beispielsweise eine Eigenschaft beziehungsweise ein Betriebsparameter der Pumpeneinrichtung 26 vorgegeben beziehungsweise gesteuert werden. Dies erfolgt je nachdem, welche Kühlleistung aktuell benötigt wird. Ebenso können mit Hilfe der Steuervorrichtung 27 die Ventile 23 bis 25 entsprechend einer benötigten Kühlleistung beziehungsweise Kühlbedarf gesteuert werden.

Eine weitere Möglichkeit ist, dass die Steuervorrichtung 27, als übergeordnetes System, mehrere einzelne Steuergeräte 28, 29 (vgl. FIG 2) aufweist. Beispielsweise kann somit dem ersten Kühlkreislauf 13 das Steuergerät 28 und dem zweiten Kühlkreislauf 14 das Steuergerät 29 zugeordnet werden. Somit kann bei der Kühlung der Magneteinheit 15 und bei sonstigen Kühlvorgängen wiederum das Steuergerät 29 und somit der Kühlkreislauf 14 inaktiv betrieben beziehungsweise geschaltet werden, um wiederum Energie einsparen zu können. Um wiederum der Steuervorrichtung 27 einen entsprechenden Input liefern zu können, können mittels einer Steuereinrichtung 30 des MRT-Systems 1 Informationen bereitgestellt werden.

Bei der Steuereinrichtung 30 kann es sich um ein MRT-System-Kontrollsystem handeln. Hierzu können Systemeigenschaften, Systeminformationen, Informationen betreffend Scan-Vorgänge oder sonstigen Informationen betreffend des MRT-Systems 1 bereitgestellt werden.

Insbesondere kann hier eine Vorhersage einer zu erwartenden Leistungsaufnahme des MRT-Systems 1 und eine voraussichtliche Wärmesituation bei einem bevorstehenden Scanvorgang durchgeführt werden. Beispielsweise kann ein Systemzustand des MRT-Systems 1 sensorisch erfasst werden, um dies wiederum als Steuergröße beziehungsweise Steuerparameter für die Steuereinrichtung 27 verwenden zu können. Des Weiteren können an den entsprechenden Komponenten 15, 17, 18 des MRT-Systems 1 Temperatursensoren angeordnet sein, um eine jeweils vorliegende Temperatur erfassen zu können. Dies kann wiederum der Steuervorrichtung 27 als Input bereitgestellt werden. Mittels dieser Informationen beziehungsweise Eingangsgrößen können die Kühlkanäle 13, 14, die Ventile 23 bis 25 und/oder die Pumpeneinrichtung 26 gesteuert werden.

Mittels des aufgeteilten Kühlsystems 12 kann eine bedarfsgerechte Kühlung des MRT-Systems 1 durchgeführt werden. Beispielsweise können die Komponenten 17, 18 wassergekühlt werden. Beispielsweise kann es sich bei den Komponenten 17, 18 um TX- und RX-Elektronik, RFPA, also eine Sendekette, Gradientenverstärker, Gradientenspule oder Elektronikschränke handeln. Diese Komponenten können beispielsweise nur so viel Kühlwasser beziehungsweise Kühlmittel erhalten, wie sie zum Abführen der entsprechenden Wärme benötigen. Hierzu können mittels der Steuervorrichtung 27 die Pumpen oder Ventile so angesteuert werden, dass eine entsprechende Durchflussmenge in den entsprechenden Kühlkreisen eingestellt ist. Die in dem zweiten Kühlkreislauf 14 größten Wärmeproduzenten sind Gradientenverstärker und Gradientenspule sowie der "REPA". Deren Wärme hängt im Wesentlichen von der gewählten Sequenz und Parametrierung des MRT-Systems 1 ab. Diese Komponenten können wiederum mit dem Teil-Kühlkreis 21 separat gekühlt werden. Die restlichen, insbesondere wassergekühlten, Komponenten 18 weisen im Wesentlichen nur eine geringe Variabilität auf. Entsprechend kann der zweite Kühlkreislauf 14 in mehrere Unterkreise beziehungsweise Teil-Kühlkreise unterteilt beziehungsweise geteilt werden. Eine beispielsweise Unterteilung kann zwischen Gradientensystem, RFPA und den restlichen Komponenten erfolgen.

Die Teil-Kühlkreise 21, 22 können entweder komplett getrennt mit eigenen Pumpen betrieben werden oder über die steuerbaren Ventile 23 bis 25 im Durchfluss begrenzt werden. Die Regulierung der Wassermenge beziehungsweise der Kühlmittelmenge der Kühlkreisläufe 13, 14, 21, 22 kann auf Basis einer Temperaturmessung der Komponenten 15, 18, 19 erfolgen.

Des Weiteren kann ein Modell, insbesondere ein simulationsbasiertes Modell, verwendet werden, um eine Abschätzung aus den Sequenzparametern des MRT-Systems 1 durchzuführen und somit eine Durchflussmenge proaktiv einzustellen. Dies kann für den RFPA von Vorteil sein, da die Zeitkonstante der Erwärmung hier am geringsten ist. Die Anpassung der Kühlleistung für den RFPA kann entsprechend schnell auf einen Leistungsanstieg reagieren. Durch die Anpassung der Durchflussmenge an die anfallende Wärmelast der Komponenten 18, 19 sinkt die Leistungsaufnahme des Kühlsystems 12, insbesondere da die Systeme in der Regel nur im Teillastbereich betrieben werden.

Bei dem RFPA kann es sich um einen "Radio Frequency Power Amplifier" handeln.

Durch die Aufteilung in mehrere Kreise kann in einem jeweiligen Kreis ein geringerer Volumenstrom vorliegen.

In der FIG 4 ist ausgehend von der FIG 3 ein weiteres schematisches Beispiel des Kühlsystems 12 dargestellt. Hierbei können der Steuervorrichtung 27 von den einzelnen Komponenten 15, 18, 19 entsprechende Statusinformationen beziehungsweise Zustandsinformationen übermittelt werden. Diese können wiederum aktuell den Betriebszustand, insbesondere die aktuelle Betriebstemperatur betreffen. Dies kann wiederum durch die Steuervorrichtung 27 für das Steuern hinsichtlich des Kühlens verwendet werden. Insbesondere kann hier ein Betriebszustand eines Heliumkompressors 31 der Magnetkühleinheit 20 der Steuervorrichtung 27 bereitgestellt beziehungsweise übermittelt werden. Mit Hilfe des Heliumkompressors 31 kann eine direkte Kühlung der Magneteinheit 15 mittels flüssigem Helium erfolgen. Hierbei kann es Informationen der aktuellen Umlaufgeschwindigkeit beziehungsweise Geschwindigkeit betreffend den Kompressor 31 bereitgestellt werden.

Beispielsweise kann bei Anpassung des Kompressors 31 der Magnetkühlung, zum Beispiel auf einen umrichtergetriebenen Kompressor, auch die Wasserkühlung betreffend den Kühlkreislauf 13 adaptiv ausgeführt werden. Hier erfolgt die Steuerung der Wassermenge beziehungsweise Kühlmittelmenge über den Aussteuergrad beziehungsweise die Frequenz, mit denen der Kompressor 31 betrieben wird. Die anfallende Wärmeleistung des Kompressors 31 kann in diesem Fall zwischen 2 Kilowatt und 6 Kilowatt variieren.

Vorteilhaft kann es sich bei den Pumpeneinheiten 28, 29, insbesondere bei der Pumpeneinrichtung 26, um Nassläuferpumpen handeln. Durch die Nutzung von Nassläuferpumpen erhöht sich die Effizienz des Kühlsystems 12 im Teillastbereich im Vergleich zu Trockenläuferpumpen. Zum effizienten Einsatz von Nassläuferpumpen kann der hydraulische Widerstand der zu kühlenden Komponenten 18, 19 reduziert werden. Hier ist vor allem der Heliumkompressor 31 ausschlaggebend, da dieser den größten Widerstand beziehungsweise Druckabfall darstellt. Dies kann durch die Nutzung anderer Wärmetauscher oder Kühlkörper erreicht werden. Neben der Steigerung der Energieeffizienz wirkt sich eine Umstellung auf Nassläuferpumpen positiv auf die Zuverlässigkeit aus.

Im Stand der Technik erfolgt die Nutzung eines gemeinsamen Kühlkreislaufes. Durch die erfindungsgemäße Aufteilung in separate Zweige beziehungsweise Kühlkreisläufe 13, 14 kann die Energieaufnahme im Kühlsystem 12 reduziert werden, da beispielsweise nur noch der Heliumkompressor 31 mit Kühlmittel versorgt werden muss. Da ein großer Teil der Energie des Kühlsystems 12 im "System-off-Modus" aufgewendet wird, wirkt sich eine Reduzierung besonders vorteilhaft aus.

Zur Vermeidung von temperaturbedingten "Drifteffekten" und Überhitzungen kann das Kühlsystem 12 mit einem konstanten Wasserdurchfluss betrieben werden. Die Umstellung auf eine bedarfsgerechte Durchflussmenge reduziert die Leistungsaufnahme des Kühlsystems 12. Zur Vermeidung von Drifteffekten und/oder Überhitzungen kann die Regelung zum Beispiel durch Informationen über die anstehende Sequenz (amplizierte Hochfrequenz-Leistung und Gradientenleistung) proaktiv die Durchflussmenge durch die Komponenten 15, 18, 19 erhöhen und reduzieren.

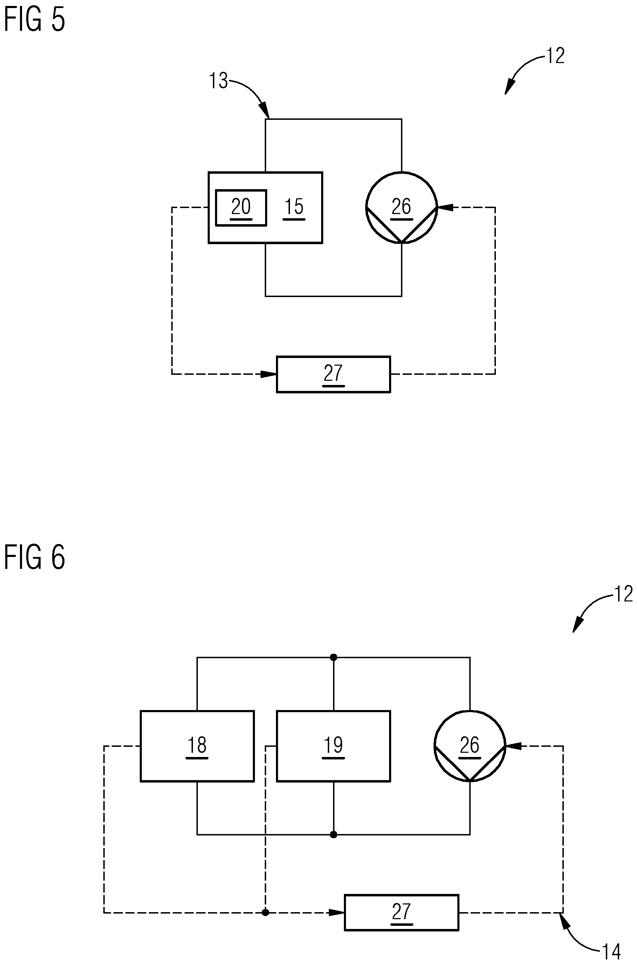

In den nachfolgenden Figuren FIG 5 bis FIG 8 sind weitere denkbare Ausführungsbeispiele betreffend das Kühlsystem 12 und speziell hier denkbare Regelungen gezeigt.

In der FIG 5 wird eine dynamische Regelung zur Wärmeübertragung einer Wärme der Magneteinheit 15 beziehungsweise der Magnetkühleinheit 20 gezeigt. Hierbei können der Steuervorrichtung 27 Statusinformationen hinsichtlich des Heliumkompressors 31 und somit der Magnetkühleinheit 20 bereitgestellt werden. Diese können über datenkommunikationstechnische Verbindungen übertragen werden. Auf Basis dieser kann die Pumpenvorrichtung 26 beziehungsweise die Pumpeneinheit 16 derart angesteuert werden, dass eine Pumpengeschwindigkeit beziehungsweise Pumpeneigenschaft an einen zu erwartenden Wärmeeintrag hinsichtlich der Magneteinheit 15 vorbereitet wird.

In der FIG 6 ist wiederum eine dynamische Regelung betreffend den zweiten Kühlkreislauf 14 dargestellt. Hierbei können der Steuervorrichtung 27 Informationen, wie zum Beispiel Temperaturen, der Komponenten 18, 19 zur Verfügung gestellt werden, um auf Basis dieser Informationen wiederum die Pumpeneinrichtung 26 und/oder die Pumpeneinheit 19 steuern zu können.

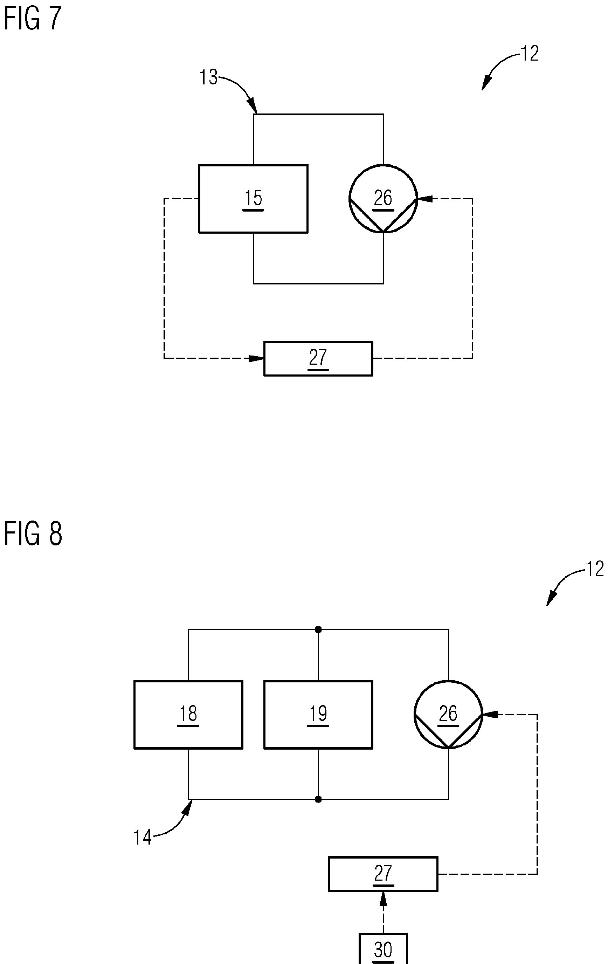

In der FIG 7 ist wiederum eine dynamische Regelung des ersten Kühlkreislaufs 13 dargestellt. Hierbei kann wiederum mittels der Steuervorrichtung 27 vorhergesagt werden, welche Temperaturentwicklung in der Magneteinheit 15 vorliegen kann, um daraufhin die Pumpeneinrichtung 27 vorkonditionieren beziehungsweise vorbereiten zu können.

In der FIG 8 ist wiederum eine dynamische Regelung des zweiten Kühlkreislaufs 14 dargestellt. Hierbei können verschiedenste Informationen der Steuereinrichtung 30 des MRT-Systems 1 der Steuervorrichtung 27 zur Verfügung gestellt werden, um auf Basis dieser wiederum den Kühlkreislauf 14 durch Ansteuerung der Pumpeneinrichtung 26 betreiben beziehungsweise steuern zu können.

## Patentansprüche

1. Kühlsystem (12) für ein Magnetresonanzsystem (1), aufweisend:
- einen ersten Kühlkreislauf (13) zur Wärmeübertragung von Wärme einer Magneteinheit (15) des Magnetresonanzsystems (1),
- zumindest einen zum ersten Kühlkreislauf (13) verschiedenen zweiten Kühlkreislauf (14) zur Wärmeübertragung von Wärme zumindest einer zur Magneteinheit (15) verschiedenen Komponente (17, 18) des Magnetresonanzsystems (1),
- zumindest eine Pumpeneinrichtung (26) zum Transport eines Kühlmediums in dem ersten Kühlkreislauf (13) und/ oder in dem zweiten Kühlkreislauf (14), und
- zumindest eine Steuervorrichtung (27) zum Steuern des ersten und/oder zweiten Kühlkreislaufs (13, 14) und der Pumpeneinrichtung (26).

2. Kühlsystem (12) nach Anspruch 1, wobei der zweite Kühlkreislauf (14) in mehrere Teilkühlkreisläufe (21, 22) unterteilt ist, wobei einer jeweiligen Komponente (17, 18) der zur Magneteinheit (15) verschiedenen Komponenten (17, 18) jeweils einer der Teilkühlkreisläufe (21, 22) zugeordnet ist.

3. Kühlsystem (12) nach Anspruch 1 oder 2, wobei die Steuervorrichtung (16) mehrere Steuergeräte (28, 29) aufweist, wobei jeweils einem Kühlkreislauf (13, 14) und/oder jeweils einem Teilkühlkreislauf (21, 22) eine der mehreren Steuergeräte (28, 29) zugordnet ist.

4. Kühlsystem (12) nach einem der vorhergehenden Ansprüche, wobei die Pumpeneinrichtung (26) zumindest zwei Pumpeneinheiten (16, 19) aufweist, wobei eine erste Pumpeneinheit (16) dem ersten Kühlkreislauf (13) und eine zweite Pumpeneinheit (19) dem zweiten Kühlkreislauf (14) zugeordnet ist.

5. Kühlsystem (12) nach Anspruch 4, wobei die Pumpeneinheiten (16, 19) als Nassläuferpumpen ausgebildet sind.

6. Kühlsystem (12) nach einem der vorhergehenden Ansprüche, wobei der erste Kühlkreislauf (13) und/oder der zweite Kühlkreislauf (14) steuerbare Ventile (23, 24, 25) aufweisen, wobei die Ventile (23, 24, 25) mittels der Steuervorrichtung (27) steuerbar sind, um eine Durchflussmenge eines Kühlmittel in dem ersten und/oder zweiten Kühlkreislauf (13, 14) anzupassen.

7. Kühlsystem (12) nach einem der vorhergehenden Ansprüche, wobei die Steuervorrichtung (27) ausgebildet ist, eine Durchflussmenge eines Kühlmediums in dem ersten und/oder zweiten Kühlkreislauf (13, 14) auf Basis eines Betriebszustands des Magnetresonanzsystems (1) zu steuern.

8. Magnetresonanzsystem (1) mit einer Bildgebungsmodalität (11) und einem Kühlsystem (12) nach einem der vorhergehenden Ansprüche.

9. Magnetresonanzsystem (1) nach Anspruch 8, wobei die Magneteinheit (15) eine Magnetkühleinheit (20) aufweist, wobei mit der Magnetkühleinheit (20) eine direkte Kühlung der Magneteinheit (15) durchführbar ist, wobei die mittels der Magnetkühleinheit (20) abgeführte Wärme der Magneteinheit (15) von dem ersten Kühlkreislauf (13) aufgenommen werden kann.

10. Magnetresonanzsystem (1) nach Anspruch 9, wobei die Magnetkühleinheit (20) einen Kompressor 31, insbesondere einen Heliumkompressor, aufweist, sodass mittels Helium die Magneteinheit (15) kühlbar ist, und wobei der erste Kühlkreislauf (13) abhängig von einem Betriebszustand des Kompressors (31) steuerbar ist.

11. Magnetresonanzsystem (1) nach Anspruch 8, 9 oder 10, wobei es sich bei der zumindest einen Komponente (17, 18) um einen Gradientenverstärker, eine Gradientenspule, einen Breitbandverstärker, eine Auswerteeinheit und/oder eine Steuereinrichtung (30) handelt.

12. Verfahren zum Kühlen eines Magnetresonanzsystems (1), wobei
- mittels eines ersten Kühlkreislaufs (13) eine Wärmeübertragung von Wärme einer Magneteinheit (15) des Magnetresonanzsystems (1) durchgeführt wird,
- mittels zumindest eines zum ersten Kühlkreislauf (13) verschiedenen zweiten Kühlkreislauf (14) eine Wärmeübertragung von Wärme zumindest einer zur Magneteinheit (15) verschiedenen Komponente (17, 18) des Magnetresonanzsystems (1) durchgeführt wird,
- mit zumindest einer Pumpeneinrichtung (26) ein Kühlmedium in dem ersten Kühlkreislauf (13) und/oder in dem zweiten Kühlkreislauf (14) transportiert wird, und
- mit zumindest einer Steuervorrichtung (27) der erste und/oder der zweite Kühlkreislauf (13, 14) und die Pumpeneinrichtung (26) zum Durchführen einer Wärmeübertragung gesteuert werden.

13. Verfahren nach Anspruch 12, wobei ein Systemzustand des Magnetresonanzsystems (1) erfasst wird, und/oder eine Temperatur der Magneteinheit (15) und/oder der zumindest einen Komponente (17, 18) erfasst wird, wobei eine Information betreffend des erfassten Systemzustands und/oder die erfasste Temperatur beim Steuern der Kühlkreisläufe (13, 14) und/oder der Pumpeneinrichtung (26) berücksichtigt werden.

14. Verfahren nach Anspruch 13, wobei auf Basis des erfassten Systemzustand, der Temperatur der Magneteinheit (15), der Temperatur der Komponente (17, 18) und/oder einer Betriebsinformation des Magnetresonanzsystems (1) eine potentielle Wärmeentwicklung der Magneteinheit (15) und/oder der zumindest einen Komponente (17, 18) prädiziert wird, wobei die prädizierte Wärmeentwicklung der Magneteinheit (15) und/oder der Komponente (17, 18) beim Steuern der Kühlkreisläufe (13, 14) und/oder der Pumpeneinrichtung (26) berücksichtigt wird.

15. Verfahren nach einem der Ansprüche 12, 13 oder 14, wobei der erste Kühlkreislauf (13) auf Basis eines Betriebszustands der Magneteinheit (15) und der zweite Kühlkreislauf (14) auf Basis eines Betriebszustands der Komponente (17, 18) gesteuert werden.
